# EUROPEAN PATENT SPECIFICATION

(11) **EP 1 633 513 B1**
(45) Date of publication and mention of the grant of the patent: **14.04.2010**
(21) Application number: 04727308.1
(22) Date of filing: 14.04.2004
(51) Int. Cl.: B22F 3/105, H01L 21/64, H01L 49/02

(54) **METHOD FOR MANUFACTURING AN ELECTRONIC COMPONENT BY SELECTIVE LASER SINTERING**
VERFAHREN ZUR HERSTELLUNG EINES ELEKTRONISCHEN BAUTEILS DURCH GEZIELTES LASERSINTERN
PROCEDE DE FABRICATION D'UN COMPOSANT ELECTRONIQUE PAR FRITTAGE SELECTIF AU LASER

(30) Priority: 15.04.2003 FI 20030570
(43) Date of publication of application: 15.03.2006
(73) Proprietor: Petäjäjärvi, Aila, 95230 Maksniemi (FI); Jokelainen, Kimmo, 91100 Ii (FI)
(72) Inventor: Petäjäjärvi, Aila, 95230 Maksniemi (FI); Jokelainen, Kimmo, 91100 Ii (FI)
(74) Representative: Brax, Matti Juhani
(86) International application number: PCT/FI2004/000230
(87) International publication number: WO 2004/091834

(56) References cited:
- WO-A1-97/38810
- DE-A1- 10 051 893
- US-A1- 5 730 925
- US-B1- 6 432 752
- CRM GROVENOR: "Microelectronic Materials" 1989, IOP PUBLISHING LTD,BRISTOL (GB), PHILADELPHIA (USA) * page 364 - page 365 *

## Description

The invention relates to a method for manufacturing a 3-dimensional at least partly ceramic component, which ceramic component comprises at least passive electrical circuit elements.

Electronic devices can be manufactured by many different manufacturing techniques. One manufacturing technique generally used nowadays is the so-called ceramic multilayer technique. When the multilayer technique is used, the ceramic circuits can be manufactured either by the HTCC technique (High Temperature Cofired Ceramics) or LTCC technique (Low Temperature Cofired Ceramics). Structures implemented by either technique consist of several ceramic layers, the thickness of which is about 100 µm, placed on top of each other. Regardless of the material, be it dielectric base material, conductor paste or via paste, they must always be manufactured separately before they are used in the component. Before the heat treatment the material is still soft, and thus it is possible to make cavities and vias of the desired shape in the ceramic layers. Likewise, it is possible to print passive circuit elements electrically at the desired points by the silk screen printing method. When the structure of the component has been assembled, the flexible layers are laminated together by means of pressure. Finally, the created structure is fired at 850°C in the case of an LTCC and at 1200°C in the case of an HTCC.

The ceramic techniques described above require many different steps of work for manufacturing both the materials used and the component itself. A prior art LTCC manufacturing process can thus contain tens of different steps of work before the product is finished. The equipment and materials used in the ceramic technique are expensive. In addition, the loss of material during the process is significant, which causes considerable additional costs per a manufactured component. This material loss/waste also causes stress on the environment.

Because the manufactured components are heated to a fairly high temperature, some organic material burns/exits from it. As a natural result of this, the material layers shrink substantially. The shrinkage can be as high as over 10 per cent. This is significant especially when manufacturing RF (Radio Frequency) circuits, in which the mechanical dimensions of the circuit entirely determine its electrical properties. Therefore, the shrinkage must be taken into account as one additional factor in the design of an RF circuit, if the ceramic technique is used. The shrinkage is a process of a random nature, and therefore it is difficult to take its effect into account in an entirely calculatory manner.

Ceramic structures can also be manufactured by so-called laser sintering. One of the best known usages of laser sintering is the layer-by-layer manufacture of quick models and moulds needed in the injection moulding technique into a piece of the desired shape. In laser sintering, a thin material layer is first spread on a substrate of a predetermined length. A laser beam is directed at the desired point in this material layer, and the laser beam sinters the material at the point in question. The material that remained at the unsintered points is removed. After this, a new layer of either the same material or some other material is spread on the substrate. A new laser sintering is performed at the desired points of the substrate. After this, the superfluous material is removed again. By repeating these steps, a three-dimensional piece of the desired shape can be built of thin layers with the thickness of a few µm.

To a certain extent, laser sintering has also been applied in the manufacture of electric circuits. US Patent 5198788 presents a method in which a part of an electric circuit on the outer surface of a ceramic component is tuned by using laser sintering. US Patent 6432752 again presents a method in which laser sintering is used in the hermetic closing of an integrated circuit. Patent application WO 97/38810 presents the manufacturing of an electric circuit by laser sintering on an existing ceramic substrate. In the method presented, the material, which is in liquid form, is sintered at the desired points on the selected substrate. In principle, the method presented can be used to manufacture multi-layer components, which contain passive circuit elements. The applications presented in the reference publication concentrate on an electric circuit created mainly in two dimensions, i.e. one level, like the traditional ceramic circuits, several parallel layers of which can then be placed on top of each other.

It is an object of the present invention to manufacture an at least partly electrical circuit solution/component based on the ceramic technique, in which the manufactured electrical circuit elements, mechanical components or electromechanical components can be built freely in any direction in three dimensions. This provides an escape from the physical and electrical limitations of components implemented on one level only.

The objectives of the invention are achieved by the method of claim 1 in which the desired electrical or electromechanical circuit solution with its components is built by laser sintering it layer by layer. Then the desired circuit structure can be manufactured in any direction in three dimensions. The electrical or mechanical connecting means required by the component can also be manufactured by the same process.

The manufacturing method according to the invention has the advantage that the component to be manufactured can be manufactured as entirely three-dimensional, and there is no need to settle for a planar implementation.

In addition, the invention has the advantage that the component to be manufactured does not shrink significantly in the manufacturing process used, because it need not necessarily be separately heat treated in a high temperature. Thus it is possible to manufacture electrical, mechanical or electromechanical components with accurate mechanical dimensions, which are used in the RF technique, for example.

In addition, the invention has the advantage that the component can be manufactured by repeating the one and the same basic processing step. The separate devices and steps of work required by the prior art process are also avoided. This invention provides saving of costs compared to the prior art process.

In addition, the invention has the advantage that the loss of material is small, because the unsintered material can be removed from the process platform and reused later.

Furthermore, the invention has the advantage that an electrical circuit or component manufactured on silicon or a corresponding material can be hermetically closed within the ceramic component being manufactured, when desired.

Furthermore, the invention has the advantage that electrical, mechanical or electromechanical parts of a component can be manufactured by the same basic process step.

A further advantage of the invention is the fact that the designed component can be manufactured in the desired shape by using some design file. For example, 3D-CAD images can be utilized in the method according to the invention.

In addition, the invention has the advantage that the process is environmentally friendly, because solvents are not necessarily needed in the manufacturing process.

The method according to the invention for manufacturing a 3-dimensional component is characterized in that at least part of the isolating elements of the ceramic components and the electrical circuit elements are manufactured layer by layer by means of laser radiation on the basis of the information of a control file formed of the component in a freely selectable structural direction within said component.

Some preferred embodiments of the invention have been presented in the dependent claims.

The basic idea of the invention is the following: The component to be manufactured is manufactured by laser sintering in its entirety. A suitable sintering platform or support material can be used in connection with sintering the first structural layers. Only by changing the material to be sintered, it is possible to grow at the desired points of the component an isolating layer, conductors, vias, notches, cavities, metallic thermal vias, passive components, optical components or electromechanical components. In the manufacturing method according to the invention, the connecting means belonging to the component, both electrical and mechanical, are preferably also laser sintered with the same process equipment as the actual electrical component. Any direction within the component can be selected as the structural direction of the circuit elements or structures being manufactured by this procedure. In addition, there is the advantageous possibility of adding - as discrete components at the desired points within the component - circuit structures implemented on silicon, for example, which can be hermetically closed within the component either by sintering or otherwise putting some suitably selected protective material on top of the circuit structure. By the manufacturing method according to the invention, the ceramic component can be manufactured by one suitable set of process equipment in its entirety.

In the following, the invention will be described in more detail. Reference will be made to the accompanying drawings, in which
- Fig. 1: presents, by way of example, a platform of process equipment used in the manufacturing method according to the invention, by which the laser sintering is performed,
- Fig. 2a: presents, by way of example, an embodiment of the platform of process equipment according to Fig. 1 in the direction of the cross-section A-B.
- Fig. 2b: presents, by way of example, another embodiment of the platform of process equipment according to the invention in the direction of the cross-section A-B of Fig. 1.
- Figs. 3a, 3b and 3c: present, by way of example, how the manufacturing method according to the invention can be utilized in the manufacturing of a component, and
- Fig. 4: presents, as an exemplary flow chart, the main steps of the manufacturing method according to the invention.

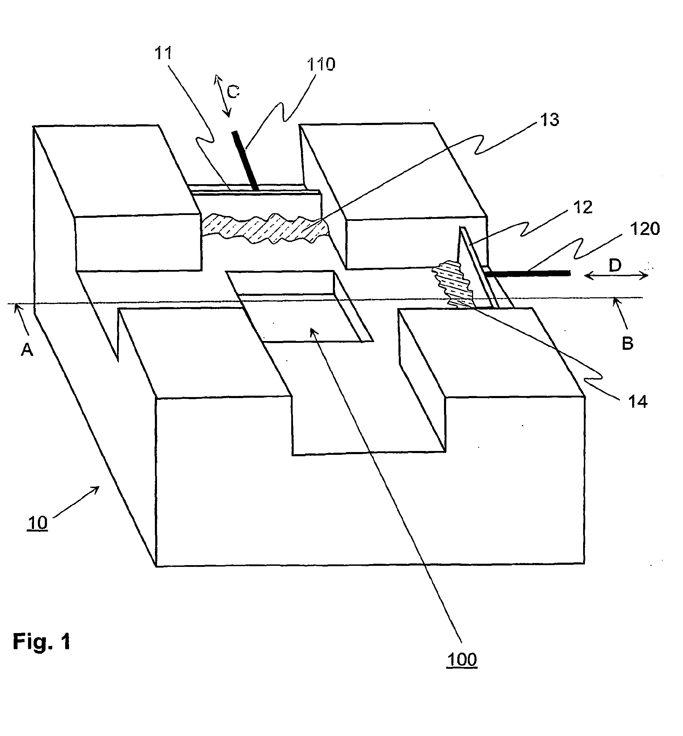

Fig. 1 shows part of the process equipment used in the manufacturing method according to the invention. Ref. no. 10 denotes the machining table of the process equipment. It has been formed so that a advantageously cross-shaped figure is formed on its upper surface. There is an opening 100 in the centre of the cross-shaped figure, in which the process platform with the shape of said opening 100 can be raised or lowered. The coating of the platform can be metal, ceramic material or some other suitable material that withstands the process heat. Material is then sintered at the desired points on this platform by using laser.

In the advantageous embodiment shown in Fig. 1, there are two material spreading blades 11 and 12 in two different branches of the formed cross. They can be moved in the directions of the arrows C and D of the control arms 110 and 120. In front of the material spreading blades 11 and 12, there is material 13 and 14 to be sintered. Advantageously, one of the materials is a suitable ceramic material for manufacturing the isolating parts required by the component and the basic structure of the component. The following materials can be advantageously used as the ceramic: MgTiO₃ CaTiO₃ ZnO, SiO₂ B₂O₃, Al₂O₃ compounds, BaTiO₃, Ba₁ₓSrₓTiO₃, PbO, BeO, SiC, AIN, Si, S₁₃N₄, diamond, quartz, steatite, titanate, mullite, alumina or glass.

The other material used is advanatageously some electrically conductive material, such as gold, silver, copper, aluminium, palladium, molybdenum, wolfram, TiO₂, BaCO₃, CoO, NiO, CuO, Mn₃O₄, RuOₓ, tantalum-aluminium mixtures, Kovar, Kanthal, nichrome, manganese. It can also be a material with some desired electrical or electromechanical effects. Materials like this are various piezoelectric materials, for example, such as zirconium oxide, titanium oxide, PZT. Ferroelectric or ferromagnetic materials, such as Fe₃O₄, AlB₂, ZnO, can also be utilized.

Various other materials needed in the manufacturing process, mainly joint and support materials, can also be spread with the equipment according to Fig. 1. Examples of possible materials are various rubbers, polyimides, polyamides, polyesters, epoxys, resins, bismaeline-triazine compounds, kaptons and aramids.

The laser tool, which belongs to the machining table 10 and actually performs the sintering when the manufacturing method according to the invention is utilized, is not shown in Fig. 1. An Eximer, Nd-YAG-, CO₂ or He-Ne-laser can be advantageously used as the laser tool that causes the sintering. The wavelength and radiation power of the laser can be advantageously adjusted according to the material being sintered. The laser tool used also needs a steering system, by which the laser beam can be steered in the X-, Y-, Θ- and Z directions. The steering system preferably utilizes a control file created of the component to be manufactured; this control file can be a 3D-CAD image/file, for example.

In Fig. 1, the material 13, 14 to be sintered is presented as being spread in powder form with one of the material spreading blades 11, 12 onto the process platform. However, the material to be sintered can also be brought to the process platform in some other form than powder to be spread by a blade. It can be brought to the desired point as melt, strip, tape, thread, net, rod, plate, paste or liquid. Spraying through a nozzle as powder or liquid only to the point being sintered each time is also possible. It is also possible to install discrete components, such as an IC, a flip chip, a silicon chip or some passive discrete component at the desired points of the component being manufactured.

The equipment used for removing the unsintered material after the laser sintering is not shown in Fig. 1, either. A suction trolley preceding or following the material spreading blade 11, 12 can advantageously be used as such removing equipment. The unsintered material can also be removed by a separate suction device. This suction device can be moved at the desired height above the component being manufactured.

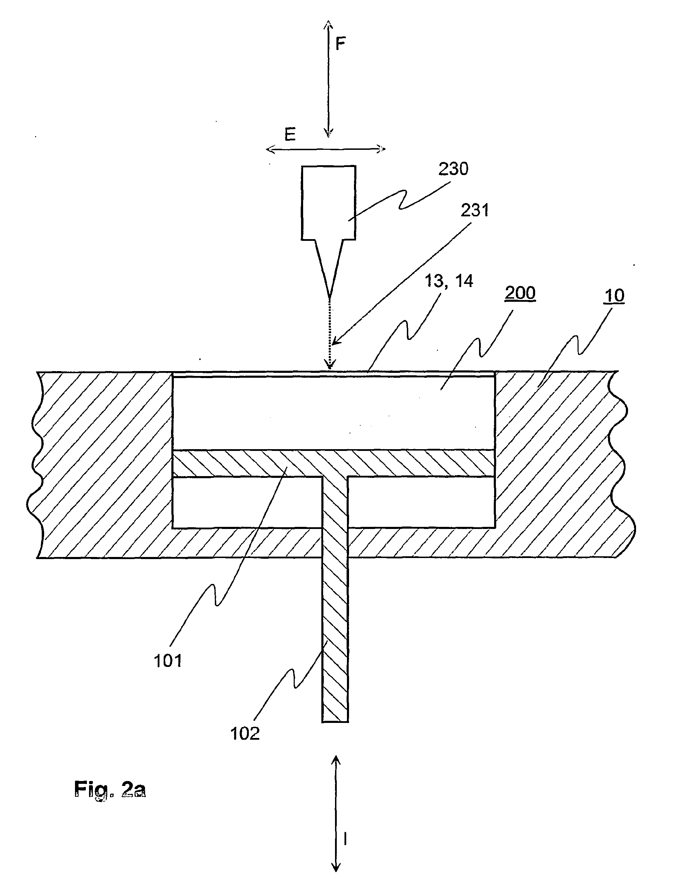

A part of the cross-section A-B presented in Fig. 1 is shown in the exemplary embodiment of Fig. 2a as seen from the side. The frame of the machining table is denoted by ref. no. 10. In a hollow of the machining table 10, ref. 100 in Fig. 1, there is a process platform 101. It can be moved in the up-down direction, which is presented by arrow I. This movement is achieved by moving the shank 102 in the desired direction for the desired length. In the example shown by Fig. 2a, part of the component 200 has already been sintered. A layer of the material to be sintered 13, 14, has been spread over this finished part 200. In connection with the example of Fig. 1, it can be of either material, ceramic or some other material needed in the manufacturing of the electrical/mechanical component.

Fig. 2a also shows a laser machining head 230, which can move in the directions of the arrows E and F in the plane of Fig. 2a. In addition, the laser machining head 230 can also be moved in a perpendicular direction to the plane of Fig. 2a, which direction is not illustrated in Fig. 2a. In this way, the sintering can be controlled in the directions of three axes, X, Y and Z, which are perpendicular to each other. In addition to the linear movement control presented, the laser machining head 230 can be tilted in relation to any one of the axes mentioned above at the angle Θ.

The movement, power and wavelength of the laser machining head 230 is controlled on the basis of a 3D-CAD file made of the product. Thus the laser beam 231 causing the sintering is in each layer focused only at the points where sintering is wanted to take place in the layer in question. When all the desired points have been sintered in the layer to be manufactured, the laser machining head 230 is set to a rest mode. After this, the unsintered material can be removed from the top of part 200. When this has been done, the next layer of the desired material 13 or 14 to be sintered can be spread and the sintering of this next layer carried out. When required, the position of the process platform 101 is changed in order to make the thickness of the material 13, 14 to be sintered comply with the target.

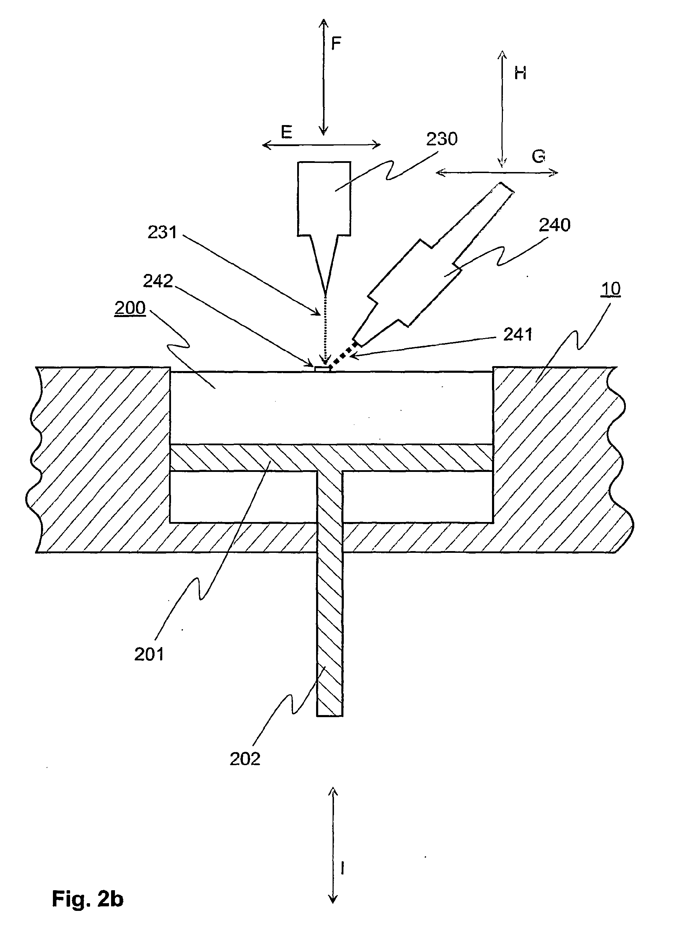

Fig. 2b shows another preferred embodiment of the invention. It differs from the embodiment of Fig. 2a in that the material to be sintered is not spread with the material spreading blades. Instead, the material to be sintered 241 can be advantageously sprayed through a nozzle 240 to the desired point 242 on top of part 200. Substantially simultaneously, a laser beam 231 that performs the sintering is directed at point 242. Only one material spraying nozzle 240 is shown In Fig. 2b, but there can naturally be more of them. In that case, each nozzle is used for spraying one material only. Two or more nozzles can be used as separate process steps either by turns on the area of the whole component or simultaneously in different parts of the component.

Like the laser machining head 230, the nozzle 240 can be controlled in three directions perpendicular to each other, which are depicted by arrows H and G in Fig. 2b, and in a direction perpendicular to the plane of Fig. 2b, which is not shown in Fig. 2b. It is also possible to tilt the nozzle 240 in relation to any of the axes mentioned above. The amount of material to be removed after sintering is thus smaller than in connection with the embodiment of Fig. 2a.

The material to be sintered, which is brought onto the surface of part 200 through the nozzle 240 can be powder, liquid or threadlike material. An essential feature is the fact that the material, which is sintered, melted or fastened immediately by means of laser radiation is brought only to the point 230 to be sintered. By using a plurality of separate nozzles, a certain layer of a component can be advantageously completed at one round of machining.

A protective gas atmosphere can also be used in the manufacturing method according to the invention, if the material to be sintered requires one. Separate post-sintering in a furnace can be used if some part to be manufactured requires it, or using it is otherwise advantageous with regard to the manufacturing process.

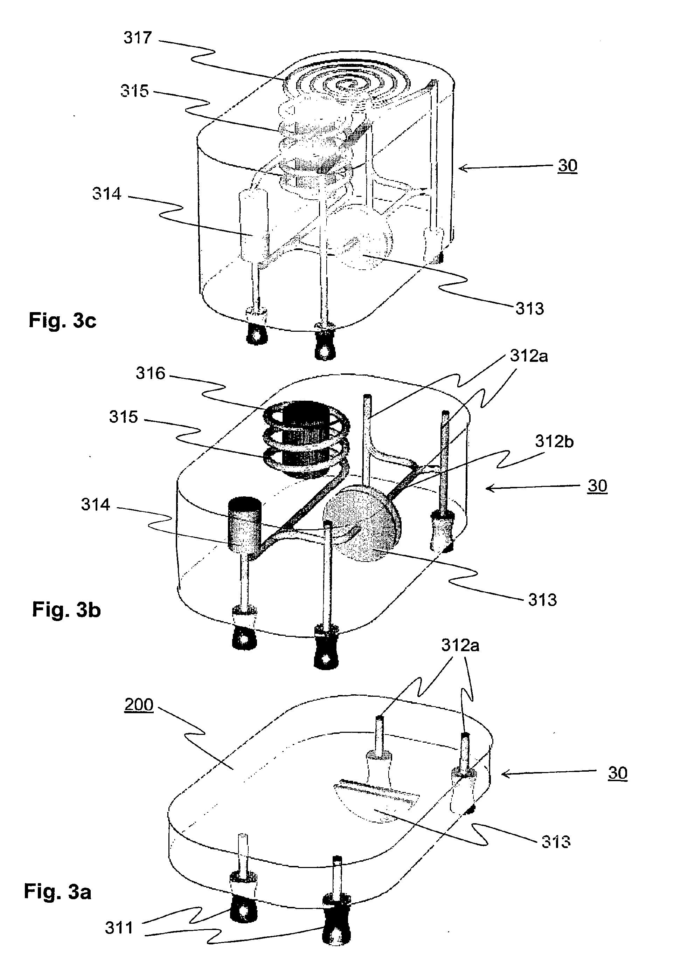

Figs. 3a, 3b and 3c show, by way of example, how the manufacturing of a ceramic component 30, in which the electrical or mechanical partial components can be manufactured in any direction within the component 30, is carried out by the manufacturing method according to the invention. The component 30 has been designed by some suitable 3D design program. The 3D-CAD file created by the design program is used in the method according to the invention to control both the spreading of the material onto the process platform and the laser equipment that cause the sintering.

In Fig. 3a, the manufacturing of the connectors 311, a part of the isolating ceramic part 200, a part of the conductors 312a and a part of the capacitor 313 has been accomplished. In the embodiment shown by the figure, the process has been started by sintering advantageously first the connectors 311. The shape of the connectors to be sintered can be spherical, angular or like an hour-glass, for example. Some support material has been layered between the connectors 311, but it is not shown in Fig. 3a. The first layer of the ceramic part 200 has then been sintered on top of this support material. On top of this ceramic part 200, either more ceramic material or some other material required in the component is sintered at the desired points. When the component 30 is finished for its essential parts, the support material between the connectors can be removed if required.

In an alternative embodiment, the component 30 is first completed at least for its essential parts, and only after that, connectors 311 of the desired shape are sintered on a suitable surface of the component 30.

Fig. 3b shows the component 30 after several times of sintering. A capacitor 313 has been manufactured in the component 30. Conductors 312a and 312b have been manufactured in the longitudinal, lateral and vertical direction of the component. Ref. no. 315 denotes a coil which has been partly completed. In the example of Fig. 3b, the inductance of coil 315 is preferably increased by means of a core 316 manufactured on the axis of the coil 315. The core 316 is preferably made of material with high permeability. In addition, Fig. 3b shows a resistor 314 belonging to the component 30, part of which has been completed.

In Fig. 3c, the component 30 is ready for installation. In the example of Fig. 3c, the component 30 comprises a resistor 314, a capacitor 313, a coil 315 and several conductors connecting components in different directions. As an example, a coil 317 has also been manufactured on an outer surface of the component 30, which coil 317 can advantageously be used as part of the antenna of a data transfer device, for example. The coil 317 shown in the figure can be manufactured by laser sintering according to the invention. However, it is also possible to manufacture it by the silk screen printing technique or some other well known manufacturing technique. In such an embodiment of the invention, the component 30 must be post-sintered in a separate sintering furnace in order to complete the coil 317. After this, the component 30 shown in Fig. 3c is ready for installation. It comprises all the desired components with their couplings and connectors 311.

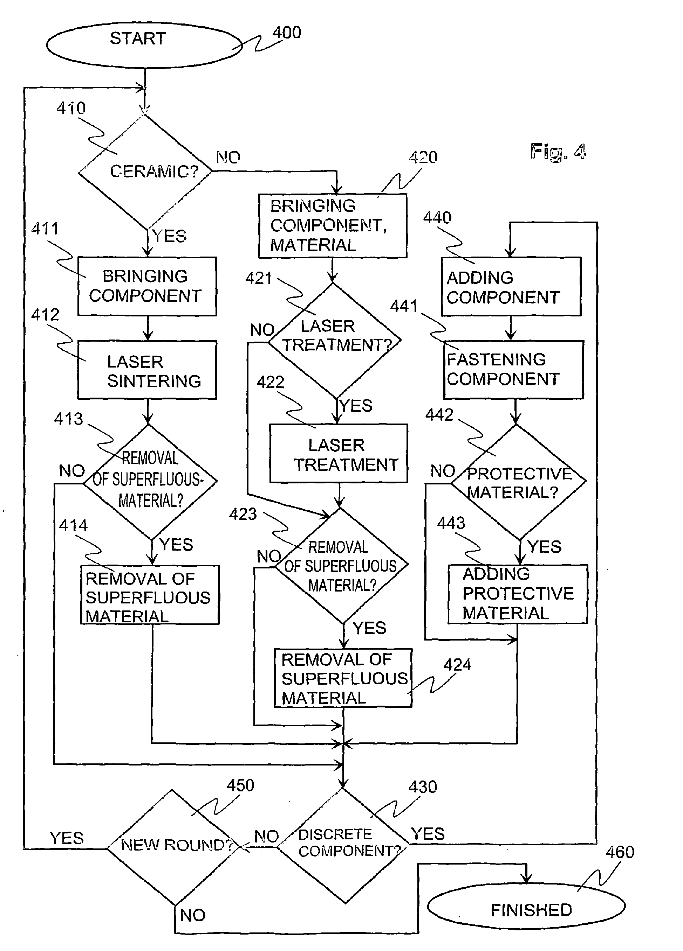

The exemplary flow chart of Fig. 4 shows the main steps of a manufacturing method according to the invention. Ref. no. 400 denotes the initial state in which the manufacturing process is started. A 3D-CAD file created by the design program of the component to be manufactured has been saved to a database, from which it can be retrieved layer by layer to be used as a control parameter in the process equipment according to the invention. In the exemplary flow chart of Fig. 4, in step 410 a selection is made for the material used on the next processing round. In this step 410, the selection can be made between a ceramic material and some other material needed in the component.

If the manufacturing of the component is started by manufacturing the ceramic, in step 411 a layer of some ceramic material having certain properties is spread on the process platform used. The spreading can be carried out either by a material spreading blade, references 11, 12 in Fig. 1, or by a nozzle, Fig. 2b, ref. 240.

In step 412, the spread ceramic material is treated by laser radiation at the points specified by the control file of the component. The treatment method used for the ceramic material is advantageously laser sintering. If this layer is intended to have holes to which some other material will be brought or connected later, these points are not radiated by laser. After the laser sintering 412, it is examined in step 413 if there remained on the process platform some material that needs to be removed before the next process round. If there is material to be removed, it is removed in step 414 preferably by means of suction. Regardless of the need to remove material, the process moves to step 430, where it is examined if some discrete component should be installed next or not. If there is no need to install a discrete component, the process moves to step 450, where it is examined if there are still planned processing rounds left. If a new processing round is not needed any more, the manufacturing of the component ends at step 460.

If there are still layers to be manufactured, the process returns to step 410, where it is again decided whether the next layer to be manufactured or a part thereof is ceramic material or some other material. In addition, the process platform is raised or lowered when required, Fig. 2a, ref. 101, so that the layer to be manufactured is at a suitable height for spreading the material to be sintered. If the next step is manufacturing a new layer of ceramic material, the process moves to step 411 again, and the manufacturing process continues in the manner described above.

Alternatively, the next step can be manufacturing a layer or part of a component of a non-ceramic material. In that case, branching takes place from step 410 to step 420, where a certain material is brought or spread on top of the previous sintered layer or process platform or to the notches and holes created in the previous sintered layer. Wen the material has been set/spread on the appropriate place, it is examined in step 421 whether the brought/spread material should be treated by laser or not. The laser treatment can be one of the following treatment methods, for example: laser sintering, melting by laser, glueing or fastening by laser If the material need not be treated by laser for some reason, the process moves directly to step 423, where the need for the removal of possible superfluous material from the process platform or the surface of the component is examined. If it is found in step 421 that a laser treatment is required, it is performed in step 422. The laser is controlled by means of a control file describing the structure of the component, which control file is preferably a 3D-CAD file.

In step 423 it is decided whether the superfluous material is removed from the surface of the component. If the removal is not required, there is no superfluous material or if the superfluous material is allowed to remain on the surface of the component, the process moves directly to step 430, which was described earlier.

If it is necessary to remove the superfluous material, it is carried out in step 424. When the superfluous material has been removed, the process moves to step 430. Through steps 430 and 450, it is possible to end up either to a new processing round through step 410 or to step 460 where the manufacturing process ends.

In step 420, the selected material can also be brought on top of the previous layer in some other form than the powder mentioned above. In that case it is advantageously a liquid, paste, thread or strip.

The manufacturing process according to the invention also enables installing discrete components, which are then in later steps hermetically covered when required during the processing rounds following the installation. Examples of such discrete components are various netlike structures, passive components, silicon chips, integrated circuits or flip chip components. These components can be fastened to the component being manufactured by glueing, soldering, bonding or sintering. The covering material selected for a discrete component is preferably the kind of material that either becomes sintered at a sufficiently low temperature without damaging the component itself or functions as a thermal insulator when the material placed on the covering material is being sintered.

The process described above is started in step 430, from which branching to the installation process of a discrete component is shown in the flow chart. In step 440, the desired discrete component is installed to the place reserved for it in the component. The actual fastening of the discrete component is carried out in step 441. The fastening of the component can be performed in any of the ways mentioned above. When the discrete component has been fastened, a decision is made in step 442 on whether it needs to be protected. If protection is not necessary, the process moves to step 430 again, and the selection process described above is repeated.

By repeating the three processing loops described above, the designed component can be built layer by layer until it is complete, by means of the control file created of the component.

The manufacturing process according to the invention does not exclude the possibility of using conventional sintering in a furnace as well. This procedure can be utilized e.g. when some material has been printed by silk screen printing or otherwise placed on the surface of the component. In this procedure, the component must additionally be separately treated in a separate sintering furnace, for example.

The following components, for example, can be advantageously manufactured by the manufacturing method according to the invention: electric modules/components, packaging, RF filters, receiver/transmitter/antenna systems, resonators, relays, contactors, transformers, switches, loudspeakers, microphones, antennas, pumps, microvalves, connection platforms, piezoactuators, various sensors and optoelectronic components.

Some preferred embodiments of the method and device according to the invention have been described above.

## Claims

1. A method for manufacturing a three-dimensional, at least partly ceramic component (30), which ceramic component (30) comprises at least passive electrical circuit elements (312a, 312b, 313, 314, 315, 317), in which manufacturing method:
- at least part of isolating ceramic elements (200) of the ceramic component (30) and the passive electrical circuit elements (312a, 312b, 313, 314, 315) are manufactured as separate, process steps comprising sintering by means of laser radiation layer by layer on the basis of the information of a control file formed of the component (30),
**characterized in that** in the manufacturing method:
- the sintering of the passive electrical circuit elements (312a, 312b, 313, 314, 315, 317) and of the isolating ceramic elements (200) is controlled in three dimensions and in freely selected structural dimensions within said ceramic component (30); and **in that**
- the manufactured isolating elements (200) hermetically enclose at least part of said passive electrical circuit elements (312a, 312b, 313, 314, 315).

2. The manufacturing method according to Claim 1, **characterized in that** said control file is a 3D-CAD file or that it has been formed thereof.

3. The manufacturing method according to Claim 1, **characterized in that** it comprises:
- a step (410) for making a decision on whether the material to be used for the next layer is ceramic material or some material needed for manufacturing a circuit component,
- a step (411) for bringing ceramic material to the process platform (201),
- a step (412) for treating the ceramic material by laser radiation (230) at points specified by a control file,
- steps (413, 414) for removing possible superfluous material, and
- a step (450) for making a decision on whether there are still other layers to be manufactured.

4. The manufacturing method according to Claim 3, **characterized in that** it also comprises
- a step (420) for bringing material needed for manufacturing a circuit component to the process platform (201),
- a step (421) for making a decision on whether or not laser is used for treating said material that was brought,
- a step (422) for treating the material needed for manufacturing a circuit component by laser (230) by means of laser radiation at points specified by the control file, and
- steps (423, 424) for removing possible superfluous material.

5. The manufacturing method according to Claim 4, **characterized in that** the material brought to the process platform (201) and to be treated by laser radiation is spread with a material spreading blade (11, 12).

6. The manufacturing method according to Claim 4, **characterized in that** the material brought to the process platform (201) and to be treated by laser radiation is spread by spraying it by means of a nozzle (240).

7. The manufacturing method according to Claim 4, **characterized in that** material or semi-finished structures are additionally brought to the process platform (201) in at least one of the following manners: as melt, in the form of thread, as strip, tape, net, rod, plate, paste or liquid.

8. The manufacturing method according to claims 1 to 7, **characterized in that** the electrical and mechanical connecting means (311) of the component (30) are also manufactured by laser treatment.

9. The manufacturing method according to claims 3 to 8, **characterized in that** the treatment by laser radiation means one of the following: laser sintering, melting by laser, glueing or fastening by laser.

10. The manufacturing method according to Claim 4, **characterized in that** the manufacturing method also comprises steps (440, 441, 442, 443), in which discrete components are additionally brought to the process platform (201) for fastening, which discrete components comprise at least one of the following: a conductor, resistor, capacitor, coil, optical element, piezoelectric element, silicon chip, integrated circuit or flip chip circuit.

## Patentansprüche

1. Verfahren zur Herstellung einer dreidimensionalen wenigstens teilweise keramischen Komponente (30), wobei die keramische Komponente (30) wenigstens passive Schaltkreiselemente (312a, 312b, 313, 314, 315, 317) umfasst, wobei in dem Herstellungsverfahren
- wenigstens ein Teil von isolierenden Keramikelementen (200) der keramischen Komponente (30) und der passiven Schaltkreiselemente (312a, 312b, 313, 314, 315) in separaten Prozessschritten, umfassend Sintern mittels Laserbestrahlung Schicht um Schicht auf der Basis der Informationen einer Steuerdatei, die aus der Komponente (30) erstellt ist, hergestellt werden,
**dadurch gekennzeichnet, dass** in dem Herstellungsverfahren
- das Sintern der passiven Schaltkreiselemente (312a, 312b, 313, 314, 315, 317) und der isolierenden Keramikelemente (200) in drei Dimensionen und in frei ausgewählten Strukturdimensionen in der keramischen Komponente (30) gesteuert wird; und darin dass
- die hergestellten isolierenden Elemente (200) wenigstens einen Teil der passiven Schaltkreiselemente (312a, 312b, 313, 314, 315) hermetisch einschließen.

2. Herstellungsverfahren nach Anspruch 1, **dadurch gekennzeichnet, dass** die Steuerdatei eine 3D-CAD-Datei ist oder **dadurch**, dass diese daraus erstellt wurde.

3. Herstellungsverfahren nach Anspruch 1, **dadurch gekennzeichnet, dass** dieses umfasst
- einen Schritt (410) zum Treffen einer Entscheidung, ob das für die nächste Schicht zu verwendende Material keramisches Material oder ein Material ist, das zur Herstellung einer Schaltkreiskomponente erforderlich ist,
- einen Schritt (411) zum Zuführen von keramischem Material zur Prozessplattform (201),
- einen Schritt (412) zum Behandeln des keramischen Materials mittels Laserbestrahlung (230) an Punkten, die von der Steuerdatei spezifiziert sind,
- Schritte (413, 414) zum Entfernen von möglichen überflüssigen Material, und
- einen Schritt (450) zum Treffen einer Entscheidung, ob noch weitere Schichten herzustellen sind.

4. Herstellungsverfahren nach Anspruch 3, **dadurch gekennzeichnet, dass** dieses ferner umfasst
- einen Schritt (420) zum Zuführen von Material, das zur Herstellung einer Schaltkreiskomponente erforderlich ist, zur Prozessplattform (201),
- einen Schritt (421) zum Treffen einer Entscheidung, ob oder ob nicht ein Laser zur Behandlung des Materials, das zugeführt wurde, verwendet wird,
- einen Schritt (422) zum Behandeln des Materials, das zur Herstellung einer Schaltkreiskomponente erforderlich ist, mittels des Lasers (230) mittels Laserbestrahlung an Punkten, die von der Steuerdatei spezifiziert sind, und
- Schritte (423, 424) zum Entfernen von möglichen überflüssigen Material.

5. Herstellungsverfahren nach Anspruch 4, **dadurch gekennzeichnet, dass** das Material, das zur Prozessplattform (201) zugeführt ist und durch Laserbestrahlung zu Behandeln ist, mit einer Materialverteilungsklinge (11, 12) verteilt wird.

6. Herstellungsverfahren nach Anspruch 4, **dadurch gekennzeichnet, dass** das Material, das zur Prozessplattform (201) zugeführt ist und mittels Laserbestrahlung zu behandeln ist, durch Sprühen desselben mittels einer Düse (240) verteilt wird.

7. Herstellungsverfahren nach Anspruch 4, **dadurch gekennzeichnet, dass** zusätzlich Material oder halbfertige Strukturen zur Prozessplattform (201) auf wenigstens eine der folgenden Arten zugeführt wird: als Schmelze, in der Form eines Strangs, als Band, Tape, Netz, Stab, Platte, Paste oder Flüssigkeit.

8. Herstellungsverfahren nach einem der Ansprüche 1 bis 7, **dadurch gekennzeichnet, dass** auch die elektrischen und mechanischen Verbindungsmittel (311) der Komponente (30) mittels Laserbehandlung hergestellt werden.

9. Herstellungsverfahren nach einem der Ansprüche 3 bis 8, **dadurch gekennzeichnet, dass** Behandlung durch Laserbestrahlung eines der Folgenden meint:
Lasersintern, schmelzen durch Laser, Kleben oder Befestigen mittels Laser.

10. Herstellungsverfahren nach Anspruch 4, **dadurch gekennzeichnet, dass** das Herstellungsverfahren ferner Schritte (440, 441, 442, 443) umfasst, in denen zusätzlich diskrete Komponenten zur Befestigungen zur Prozessplattform (201) zugeführt werden, wobei die diskreten Komponenten wenigstens eines der Folgenden Umfasst: einen Leiter, einen Widerstand, eine Kapazität, eine Wicklung, ein optisches Element, ein piezoelektrisches Element, ein Siliziumchip, einen integrierten Schaltkreis oder einen Flip-Chip-Schaltkreis.

## Revendications

1. Procédé de fabrication d'un composant tridimensionnel au moins partiellement céramique (30), ledit composant céramique (30) comprenant au moins des éléments de circuit électriques passifs (312a, 312b, 313, 314, 315, 317), dans ledit procédé de fabrication :
- au moins une partie des éléments céramiques isolants (200) du composant céramique (30) et les éléments de circuit électriques passifs (312a, 312b, 313, 314, 315) sont fabriqués lors d'étapes de traitement distinctes comprenant le frittage à l'aide d'un rayonnement laser couche par couche sur la base des informations d'un fichier de commande formé du composant (30),
**caractérisé en ce que** dans le procédé de fabrication :
- le frittage des éléments de circuit électriques passifs (312a, 312b, 313, 314, 315, 317) et des éléments céramiques isolants (200) est commandé en trois dimensions et en dimensions structurales librement sélectionnées dans ledit composant céramique (30) ; et **en ce que**
- les éléments isolants fabriqués (200) renferment hermétiquement au moins une partie desdits éléments de circuit électriques passifs (312a, 312b, 313, 314, 315).

2. Procédé de fabrication selon la revendication 1, **caractérisé en ce que** ledit fichier de commande est un fichier 3D-CAD ou **en ce qu'**il a été formé de ce dernier.

3. Procédé de fabrication selon la revendication 1, **caractérisé en ce qu'**il comprend :
- une étape (410) servant à prendre une décision pour savoir si le matériau à utiliser pour la couche suivante est un matériau céramique ou un matériau nécessaire à la fabrication d'un composant de circuit,
- une étape (411) servant à apporter le matériau céramique sur la plateforme de traitement (201),
- une étape (412) servant à traiter le matériau céramique par rayonnement laser (230) en des points spécifiés par un fichier de commande,
- des étapes (413, 414) servant à retirer l'éventuel matériau superflu, et
- une étape (450) servant à prendre une décision pour savoir s'il y a encore d'autres couches à fabriquer.

4. Procédé de fabrication selon la revendication 3, **caractérisé en ce qu'**il comprend également
- une étape (420) servant à apporter le matériau nécessaire à la fabrication d'un composant de circuit sur la plateforme de traitement (201),
- une étape (421) servant à prendre une décision pour savoir si un laser est utilisé ou non pour traiter ledit matériau qui a été apporté,
- une étape (422) servant à traiter le matériau nécessaire à la fabrication d'un composant de circuit par laser (230) à l'aide d'un rayonnement laser en des points spécifiés par le fichier de commande, et
- des étapes (423, 424) servant à retirer l'éventuel matériau superflu.

5. Procédé de fabrication selon la revendication 4, **caractérisé en ce que** le matériau apporté sur la plateforme de traitement (201) et à traiter par rayonnement laser est étalé à l'aide d'une lame d'étalement de matériau (11, 12).

6. Procédé de fabrication selon la revendication 4, **caractérisé en ce que** le matériau apporté sur la plateforme de traitement (201) et à traiter par rayonnement laser est étalé en le projetant à l'aide d'une buse (240).

7. Procédé de fabrication selon la revendication 4, **caractérisé en ce que** des matériaux ou structures semi-finies sont en plus apportés sur la plateforme de traitement (201) dans au moins une des manières suivantes : en coulée, sous la forme de fil, en bande, ruban, filet, tige, plaque, pâte ou liquide.

8. Procédé de fabrication selon les revendications 1 à 7, **caractérisé en ce que** les moyens de liaison électriques et mécaniques (311) du composant (30) sont également fabriqués par traitement laser.

9. Procédé de fabrication selon les revendications 3 à 8, **caractérisé en ce que** le traitement par rayonnement laser désigne l'un des traitements suivants : frittage au laser, fusion par laser, collage ou fixation par laser.

10. Procédé de fabrication selon la revendication 4, **caractérisé en ce que** le procédé de fabrication comprend également des étapes (440, 441, 442, 443), dans lesquelles des composants distincts sont en plus apportés sur la plateforme de traitement (201) pour fixation, lesdits composants distincts comprenant au moins un des composants suivants : un conducteur, une résistance, un condensateur, une bobine, un élément optique, un élément piézoélectrique, une puce de silicium, un circuit intégré ou un circuit à puce retournée.
